(19) Europäisches Patentamt
European Patent Office
Office européen des brevets

(11) **EP 0 801 467 B1**

(12) **FASCICULE DE BREVET EUROPEEN**

(45) Date de publication et mention
de la délivrance du brevet:
**23.10.2002 Bulletin 2002/43**

(51) Int Cl.⁷: $H03F\ 3/60$

(21) Numéro de dépôt: **97400744.5**

(22) Date de dépôt: **01.04.1997**

(54) **Amplificateur distribué adaptateur basse impédance pour émetteur optoélectronique de signaux hyperfréquences à trés large bande**

Kettenverstärkender Adapter niedriger Impedanz für einen optoelektronischen Mikrowellensender mit sehr grosser Bandbreite

Low impedance distributed amplifier adapter for opto-electronic microwave signal transmitter with very wide band

(84) Etats contractants désignés:
**DE ES GB IT**

(30) Priorité: **11.04.1996 FR 9604524**

(43) Date de publication de la demande:
**15.10.1997 Bulletin 1997/42**

(73) Titulaire: **THALES SYSTEMES AEROPORTES S.A.**
**92210 Saint-Cloud (FR)**

(72) Inventeurs:
• **Dueme, Philippe**
**91140 Villejust (FR)**
• **Schaller, Michel**
**78890 Garancieres (FR)**

(74) Mandataire: **Plaçais, Jean-Yves et al**
**Cabinet Netter,**
**36, avenue Hoche**
**75008 Paris (FR)**

(56) Documents cités:
**US-A- 4 540 954      US-A- 4 947 136**
**US-A- 5 485 118**

• **PROCEEDINGS OF THE GALLIUM ARSENIDE INTEGRATED CIRCUIT SYMPOSIUM (GAAS IC), NEW ORLEANS, OCT. 7 - 10, 1990, no. SYMP. 12, 7 - 10 Octobre 1990, INSTITUTE OF ELECTRICAL AND ELECTRONICS ENGINEERS, pages 121-124, XP000223254 DUEME PH ET AL: "ADVANCED DESIGN FOR WIDEBAND MMIC POWER AMPLIFIERS"**

## Description

La présente invention concerne un amplificateur distribué adaptateur basse impédance pour émetteur optoélectronique de signaux hyperfréquences à très large bande.

Elle trouve une application en optoélectronique, dans la fabrication de circuits intégrés monolithiques hyperfréquences destinés à la transmission de signaux hyperfréquences sur fibres optiques.

Les systèmes hyperfréquences dans le domaine du radar, de la guerre électronique et des applications de télécommunications, augmentent continuellement leur niveau de complexité, et utilisent de plus en plus des liaisons hyperfréquences.

Compte tenu des avantages conférés par les fibres optiques, notamment en termes d'encombrement et de pertes, les liaisons hyperfréquences utilisent de plus en plus de fibres optiques et des transducteurs optoélectroniques tels que des diodes laser et des photodiodes.

Or, les diodes laser ont une impédance d'environs quelques Ohms, inférieure à l'impédance normalisée de 50 $\Omega$ des circuits électroniques de commande des signaux hyperfréquences.

Il en résulte un mauvais rendement de la liaison optique sur le plan du gain, du facteur de bruit et de la dynamique.

Pour améliorer l'adaptation d'impédance, une solution connue consiste à mettre en série, avec la diode laser, une résistance complémentaire de l'ordre de 45 $\Omega$.

Toutefois, une telle solution a l'inconvénient d'engendrer une perte de puissance d'environ 10 dB.

Par ailleurs, on connaît des amplificateurs à large bande en hyperfréquences, appelés amplificateurs distribués, et qui sont capables de fonctionner sur une très large bande, avec une platitude de gain excellente.

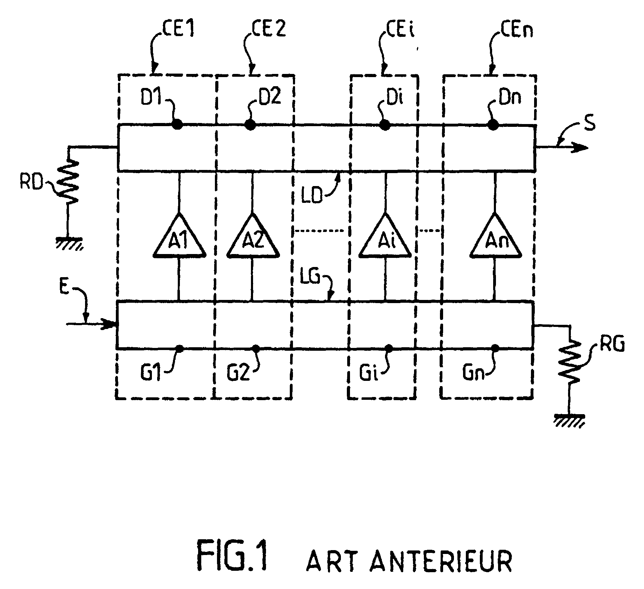

Sur la figure 1, un amplificateur distribué à large bande de fréquences de l'art antérieur comprend n cellules amplificatrices CE montées entre une ligne de grille LG et une ligne de drain LD. Chaque cellule CE individualisée en CE1 à CEn comporte une structure amplificatrice A individualisée en A1 à An et possédant, le plus souvent, un transistor à effet de champ T individualisé en T1 à Tn, et monté en source commune. Des éléments passifs servant à constituer des équivalents de tronçons de la ligne de drain et de la ligne de grille (non représentés) complètent chaque cellule amplificatrice.

Chaque transistor T, par exemple le transistor T1 est interconnecté entre un point G, par exemple le point G1, de la ligne de grille LG et un point D, par exemple le point D1 de la ligne de drain LD. La ligne de drain est parfois appelée "ligne de drains commune" dans la mesure où tous les drains des transistors sont reliés sur cette ligne. De même, la ligne de grille est parfois appelée "ligne de grilles commune" dans la mesure où toutes les grilles des transistors sont reliées sur cette même ligne.

La tête de la ligne de grille LG forme l'entrée E de l'amplificateur distribué. L'autre extrémité de la ligne de grille est chargée sur une résistance terminale RG qui est sensiblement égale à l'impédance caractéristique de la ligne de grille. Inversement, l'une des extrémités de la ligne de drain est chargée sur une résistance terminale RD sensiblement égale à l'impédance caractéristique de la ligne de drain, tandis que l'autre extrémité de la ligne de drain définit la sortie S de l'amplificateur distribué.

Des premiers moyens de polarisation (non représentés) appliquent une première tension de polarisation à la ligne de grille LG, et des seconds moyens de polarisation (non représentés) appliquent une seconde tension de polarisation à la ligne de drain LD.

Le principe de fonctionnement de l'amplificateur distribué de la figure 1 est le suivant :

Le signal d'entrée se propage sur la ligne de grille LG. Chaque structure amplificatrice, par exemple la structure A1 le reçoit en son point G1, et fournit à la ligne de drain en son point D1, une version amplifiée du signal d'entrée, version qui se propage sur cette ligne de drain LD.

Dans cette application connue d'amplification, les tensions continues de polarisation des lignes de grille et de drain sont appliquées à travers des résistances terminales identiques de 50 $\Omega$.

On connaît aussi d'après le document EP-A-0 404 632, un dispositif électronique adaptateur basse impédance à large bande de fréquences ayant une structure de type amplificateur distribué, et comprenant ng lignes de grille et nd lignes de drain montées en parallèle (avec ng et nd entiers supérieurs ou égaux à 1). Le rapport d'adaptation d'impédance entre l'entrée et la sortie du dispositif est lié ici au rapport ng/nd.

Un tel dispositif a l'inconvénient d'être complexe à mettre en oeuvre, et d'occuper une surface importante à cause des ng et nd lignes de grille et de drain à implémenter.

La présente invention a pour objet de remédier à ces problèmes.

Elle porte sur un amplificateur distribué pour signaux hyperfréquences à très large bande, destiné à être interposé entre un circuit électronique amont d'impédance prédéterminée, et un circuit électronique aval de basse impédance par rapport à celle du circuit électronique amont, ledit amplificateur comprenant une pluralité de cellules amplificatrices montées chacune entre une ligne de grille et une ligne de drain, chaque cellule comportant un circuit actif possédant au moins un transistor à effet de champ monté en source commune, et des éléments passifs servant à constituer des équivalents de tronçons de la ligne de drain et de la ligne de grille.

Selon une définition générale de l'invention, l'une des extrémité de la ligne de grille, formant l'entrée de l'amplificateur distribué, est reliée au circuit électronique amont ; l'une des extrémités de la ligne de drain, formant la sortie de l'amplificateur distribué, est reliée au circuit électronique aval ; et les valeurs des éléments passifs servant à constituer les équivalents de tronçons de la ligne de drain et/ou de la ligne de grille de chaque cellule sont choisies de manière appropriée pour que l'impédance caractéristique de chaque cellule soit plus petite que celle de la cellule précédente, selon le sens de propagation des signaux hyperfréquences, et conformément à une loi choisie, afin d'amener progressivement l'impédance caractéristique de la ligne de drain à une valeur choisie permettant une adaptation basse impédance entre les circuits électroniques amont et aval, tout en conservant un gain plat et sans discontinuité sur la très large bande de fréquences.

Une telle structure a l'avantage de fournir une adaptation basse impédance et large bande, de manière simple, peu encombrante et facile à mettre en oeuvre, sans engendrer de perte de puissance comme la solution à résistance complémentaire de l'art antérieur et avec une amélioration d'environ 5 à 10 dB obtenue grâce au gain de l'amplificateur distribué.

D'autres caractéristiques et avantages de l'invention apparaîtront à la lumière de la description détaillée ci-après et des dessins annexés dans lesquels :

- la figure 1 est un schéma de principe d'un amplificateur distribué à très large bande de fréquences de l'art antérieur ;

- la figure 2 est un schéma de principe d'un amplificateur distribué adaptateur basse impédance à très large bande selon l'invention

- la figure 3 est un dessin de masque de l'amplificateur distribué de la figure 2, en technologie de circuit intégré monolithique hyperfréquence selon l'invention ;

- les figures 4A à 4D représentent respectivement des liaisons à fibres optiques avec ou sans amplificateur distribué hyperfréquence selon l'invention ; et

- les figures 5 à 7 représentent des courbes illustrant le bilan des liaisons des dispositifs décrits en référence aux figures 4A à 4D.

Les dessins annexés comportent pour l'essentiel des éléments de caractère certain. Ils pourront donc non seulement servir à mieux faire comprendre la description détaillée ci-après, mais aussi contribuer à la définition de l'invention, le cas échéant.

La Demanderesse s'est posé le problème d'utiliser l'amplificateur distribué hyperfréquence décrit en référence à la figure 1, non seulement pour assurer une fonction d'amplification, mais aussi pour exercer une fonction d'adaptation basse impédance, tout en conservant un gain plat et sans discontinuité sur la très large bande de fréquences. Elle s'est posé aussi le problème de fournir un dispositif simple, peu encombrant, facile à mettre en oeuvre et présentant un haut rendement de fabrication.

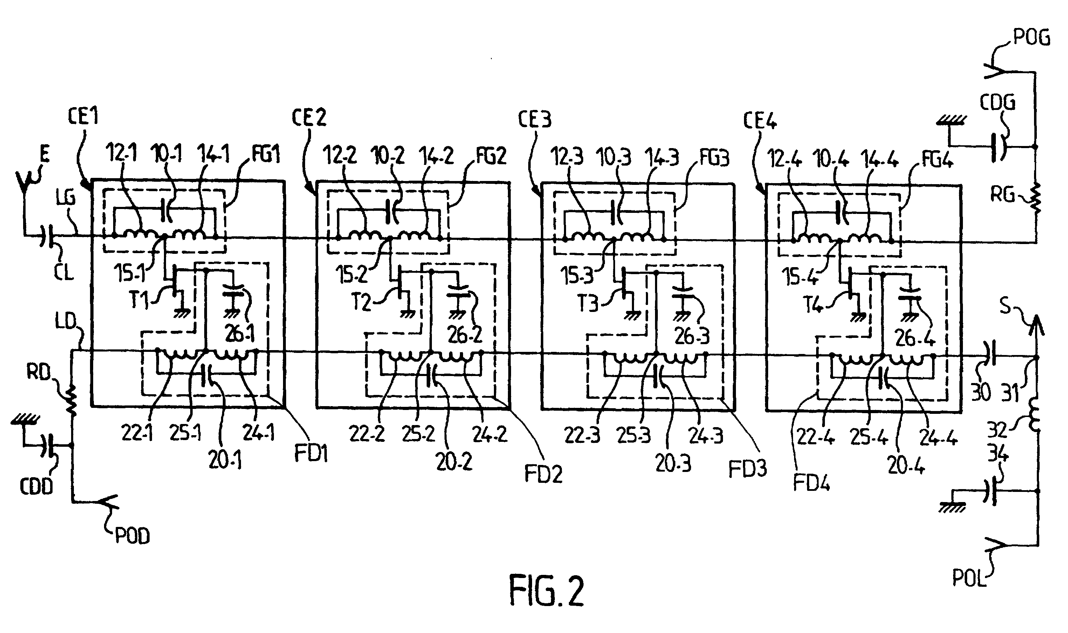

La solution proposée selon la présente invention consiste, en référence à la figure 2, à effectuer notamment les modifications suivantes par rapport à l'amplificateur distribué décrit en référence à la figure 1.

Tout d'abord, l'une des extrémités de la ligne de grille LG, formant l'entrée E de l'amplificateur distribué, est reliée à un circuit électronique amont (non représenté), qui est par exemple un dispositif de commande pour diodes laser.

Ensuite, l'une des extrémité de la ligne de drain LD, formant la sortie S de l'amplificateur distribué, est reliée à un circuit électronique aval, par exemple une diode laser.

Enfin, et surtout, les valeurs des éléments passifs servant à constituer les équivalents de tronçons de la ligne de drain et/ou de la ligne de grille de chaque cellule, sont choisies de manière appropriée pour que l'impédance caractéristique de chaque cellule soit plus petite que celle de la cellule précédente, selon le sens de propagation des signaux hyperfréquences et conformément à une loi choisie, afin d'amener progressivement l'impédance caractéristique de la ligne de drain à une valeur choisie permettant une adaptation basse impédance entre les circuits électroniques amont et aval, tout en conservant un gain plat et sans discontinuité sur la très large bande de fréquences.

De manière connue, la structure de l'amplificateur de la figure 2 selon l'invention est complétée de la manière suivante par rapport à l'amplificateur distribué décrit en référence à la figure 1.

La première tension de polarisation POG est appliquée à l'autre extrémité de la ligne de grille LG à travers une première résistance terminale RG d'une valeur ohmique prédéterminée, en pratique 50 $\Omega$, c'est-à-dire l'impédance caractéristique du circuit amont.

Par ailleurs, la seconde tension de polarisation POD est appliquée à l'autre extrémité de la ligne de drain LD à travers une seconde résistance terminale RD d'une valeur ohmique plus faible que celle de la première résistance terminale, en pratique 10 $\Omega$, c'est-à-dire l'impédance caractéristique du circuit aval ici une diode laser.

Une capacité de découplage CDG, reliée à la masse, est montée en parallèle entre la résistance terminale RG et le circuit de polarisation délivrant la tension POG.

De même, une capacité de découplage CDD reliée à la masse, est montée en parallèle entre la résistance terminale RD et le circuit de polarisation délivrant la tension POD.

Par ailleurs, une capacité de liaison CL est prévue entre l'entrée de l'amplificateur distribué E et la première cellule amplificatrice CE1. De même, une autre capacité de liaison 30 est prévue entre la sortie de la dernière cellule amplificatrice CE4 et la sortie S de l'amplificateur distribué.

En ce qui concerne la diode laser, il est prévu un circuit de polarisation spécifique agencé de la manière suivante. Le point commun 31 de la capacité de liaison 30 et de la sortie S est relié au circuit de polarisation délivrant la tension de polarisation POL de la diode laser à travers une inductance 32 et une capacité de découplage 34 montée en parallèle et reliée à la masse.

D'une manière également connue, les éléments passifs servant à constituer les équivalents de tronçons de la ligne de grille FG (par exemple FG1), de chaque cellule (par exemple la cellule CE1) comprennent deux inductances en série 12-1, 14-1 et une capacité 10-1 montée en parallèle sur ces deux inductances 12-1 et 14-1. Les deux inductances comprennent une mutuelle inductance. Avec la capacité grille-source du transistor, une telle structure est équivalente à un filtre de type passe-tout.

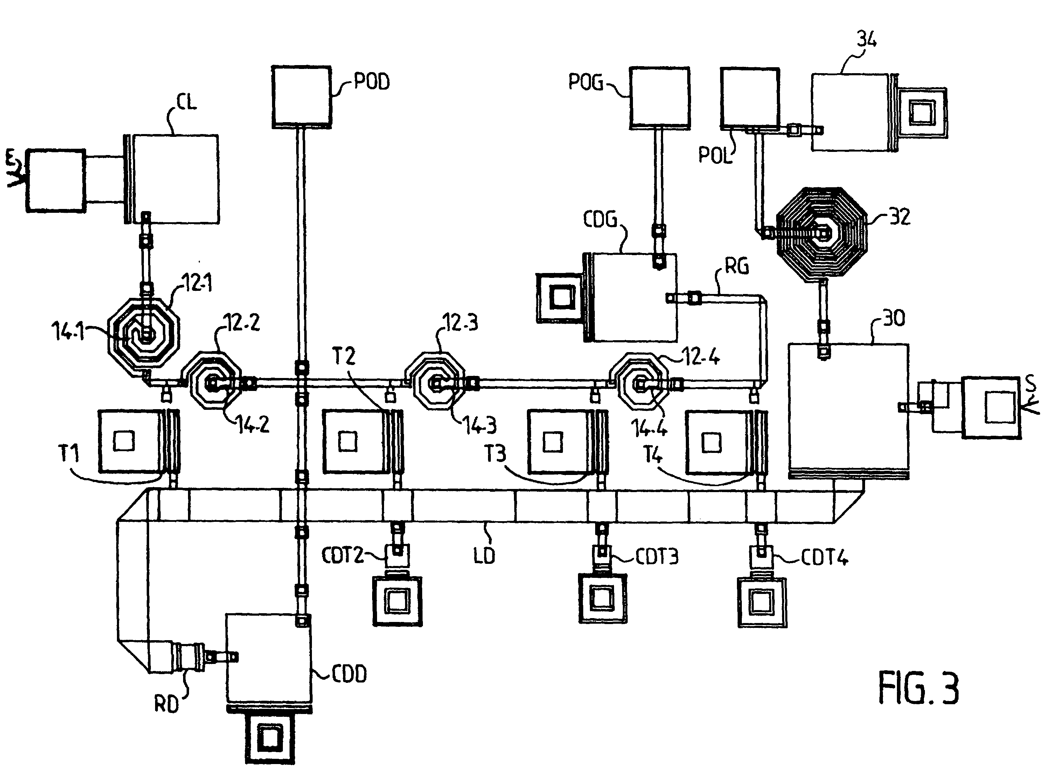

Comme on le verra plus en détail en référence à la figure 3, la capacité 10-1 n'est pas matérialisée dans la mesure où elle a ici une valeur très faible, non matérialisable. Elle est donc répartie dans les inductances 12-1 et 14-1. Le point commun 15-1 des deux inductances 12-1 et 14-1 est par conséquent relié à la grille du transistor T1. La valeur de la mutuelle inductance est ici avantageusement nulle. Les éléments passifs FG ainsi agencés sont équivalents à un filtre de type passe-bas.

De même, de manière également connue, les éléments passifs servant à constituer les équivalents de tronçons de ligne de drain FD (par exemple FD1), de chaque cellule (par exemple la cellule CE1) comprennent deux inductances en série 22-1 et 24-1 et une capacité 20-1 montée en parallèle sur ces deux inductances 22-1 et 24-1. Les deux inductances comprennent une mutuelle inductance. Avec la capacité drain-source du transistor, une telle structure est équivalente à un filtre de type passe-tout.

La capacité 20-1 n'est pas matérialisée conformément à la figure 3 dans la mesure où elle est ici de faible valeur et répartie dans les inductances 22-1 et 24-1. Le point commun 25-1 des deux inductances 22-1 et 24-1 est par conséquent relié au drain du transistor T1. La valeur de la mutuelle inductance est ici avantageusement nulle. Entre le point commun 27-1 du drain et de la masse, est montée une capacité 26-1 que l'on décrira plus en détail ci-après. Les éléments passifs FD ainsi agencés sont équivalents à un filtre de type passe-bas.

La Demanderesse a observé de façon surprenante qu'en modifiant les valeurs des éléments passifs FD et/ou FG d'une cellule par rapport à celles de la cellule suivante, et qu'en choisissant de manière appropriée ces valeurs selon une loi choisie, une adaptation basse impédance est obtenue entre les circuits amont et aval de l'amplificateur distribué, tout en conservant une platitude de gain sur toute la largeur de bande hyperfréquences.

Selon un premier mode de réalisation décrit en référence à la figure 2, seules les valeurs des éléments passifs FD de chaque cellule sont différentes d'une cellule à l'autre, tandis que les valeurs des éléments passifs FG sont constantes d'une cellule à l'autre.

Dans un second mode de réalisation (non représenté), les valeurs des éléments passifs FG varient aussi d'une cellule à l'autre, de façon décroissante selon le sens de propagation des signaux hyperfréquences. Un tel second mode est avantageux car il permet de diminuer le rapport élevé entre l'impédance équivalente de la ligne de drain et l'impédance équivalente de la ligne de grille de la dernière cellule, mais il engendre une désadaptation d'impédance.

Toute la difficulté de la présente invention est de choisir les valeurs des éléments passifs FD et/ou FG d'une cellule à l'autre afin d'obtenir l'adaptation basse impédance, tout en conservant une platitude de gain sur la très large bande hyperfréquences.

La Demanderesse a tout d'abord observé que ces valeurs doivent vérifier certaines conditions pour que l'amplificateur distribué fonctionne correctement.

Tout d'abord, il est nécessaire que les signaux qui se propagent selon les deux lignes LG et LD se recombinent en phase à chaque cellule. Dans le cadre du mode de réalisation préféré de l'invention, l'impédance du circuit électronique amont tel qu'un dispositif de commande habituellement utilisé pour commander une diode laser, est normalisée à 50 $\Omega$, tandis que l'impédance du circuit aval, telle qu'une diode laser est de quelques Ohms, typiquement entre 5 et 10 $\Omega$.

Ainsi, pour que les deux lignes LG et LD soient adaptées en impédance, il faut que le rapport 2LGG/CGS soit égal au carré de 50 $\Omega$ tandis que le rapport 2LDD/CD soit égal au carré de 10 $\Omega$ avec LGG égale à la sommes des inductances 12 et 14, CGS égale à la capacité grille-source du transistor, LDD égale à la somme des inductances 22 et 24, et CD égale à la somme des capacités drain-source du transistor et de la capacité 26.

Pour chaque cellule, l'égalisation des vitesses de phase impose que les produits 2LGG.CGS et 2LDD. CD soient égaux.

Dans la pratique, les transistors à effet de champ possède une capacité grille-source bien supérieure à leur capacité drain-source.

Par exemple, les transistors à effet de champ utilisés dans l'amplificateur distribué décrit en référence à la figure 2 sont du type HEMT pour High Electron Mobility Transistor, fabriqués selon le procédé THOMSON/TCS de type VLN02/HEMT.

En pratique, de tels transistors possèdent une capacité grille-source d'environ 109 $10^{-15}$ F et une capacité drain-source d'environ 28 $10^{-15}$ F.

Pour satisfaire les deux conditions précitées, on choisit alors de faire varier la valeur de la capacité 26 d'une cellule à l'autre de façon croissante vers la sortie de l'amplificateur.

La Demanderesse a obtenu une adaptation basse impédance 50 Ω-10 Ω pour une diode laser avec un amplificateur distribué de quatre cellules et dont les valeurs des éléments sont les suivants compte tenu des nombreux parasites inhérents aux composants (bien évidemment, d'autres configurations avec d'autres valeurs peuvent aussi convenir selon l'invention) :

- tension de polarisation drains POD égale à 3 V,
- tension de polarisation grille POG égale à -0,5 V < POG < -0,2 V,
- inductances 12-1 à 12-4, et 14-1 à 14-4 égales à 137 $10^{-12}$ H,
- capacités 10-1 à 10-4 égales à 27 $10^{-15}$ F (non matérialisée dans la mesure où les valeurs sont très faibles. Ces capacités sont intégrées dans les inductances 12 et 14),
- inductances 22-1 et 24-1 égales à 55 $10^{-12}$ H,
- capacité 20-1 égale 69 $10^{-15}$ F,
- capacité 26-1 égale à 229 $10^{-15}$ F.

L'homme de l'art remarquera que pour cette première cellule CE1, les deux équations précitées sont vérifiées.

En ce qui concerne la cellule CE2, les valeurs des éléments de filtrage-drain sont les suivantes :

- inductances 22-2 et 24-2 égales à 39 $10^{-12}$ H,
- capacité 20-2 égale à 97 $10^{-15}$ F, et
- capacité 26-2 égale à 344 $10^{-15}$ F.

En ce qui concerne la cellule CE3, les valeurs des éléments de filtrage-drain sont les suivantes :

- inductances 22-3 et 24-3 égales à 32 $10^{-12}$ H,
- capacité 20-3 égale à 119 $10^{-15}$ F, et
- capacité 26-3 égale à 432 $10^{-15}$ F.

Enfin, pour la cellule CE4, les valeurs des éléments de filtrage-drain sont les suivantes :

- inductances 22-4 et 24-4 égales à 27 $10^{-15}$ H,
- capacité 20-4 égale à 137 $10^{-15}$ F, et
- capacité 26-4 égale à 0,5 $10^{-12}$ F.

L'homme du métier remarquera que les équations précitées sont vérifiées pour chacune des cellules CE1 à CE4.

De plus, il observera que l'impédance caractéristique de chaque cellule diminue par rapport à celle de la cellule précédente, selon la loi suivante :

$$Zcer = Zcd \, (nce/r)^x$$

avec:

- nce = nombre de cellules, ici nce = 4,
- r = rang de la cellule,
- Zcer impédance caractéristique de la cellule CE de rang r,
- Zcd impédance caractéristique de la charge de sortie, ici égale à 10 Ω,
- x réel, 0 < x <1

Par exemple, avec x=0,5, l'impédance caractéristique de la cellule CE1 est égale à $10(4/1)^{0,5}$ = 20 et l'impédance caractéristique de la cellule CE4 est égale à $10(4/4)^{0,5}$ = 10.

Il remarquera que ce sont les valeurs des inductances 22 et 24 ainsi que de la capacité 26 qui sont réellement modifiées d'une cellule à l'autre pour obtenir l'adaptation basse impédance choisie.

En référence à la figure 3, l'homme du métier reconnaît le dessin de masque de l'amplificateur distribué décrit en référence à la figure 2, en technologie de circuit intégré monolithique en hyperfréquences, appelé encore MMIC pour Monolithic Microwave Integrated Circuit.

On y retrouve les moyens essentiels et constitutifs de l'amplificateur distribué selon l'invention.

Il convient de remarquer que ce dessin de masque a l'avantage de fournir un amplificateur distribué peu encombrant, simple et facile à mettre en oeuvre avec un haut rendement de fabrication.

Il est à noter que les capacités 10 et 20 ne sont pas matérialisées sur ces dessins de masque dans la mesure où elles ont une valeur très faible, non matérialisable, et directement intégrées dans les inductances 12 et 14 d'une part, et 22 et 24 d'autre part.

Il est à observer aussi que les inductances-grilles respectent des règles de dessin connues de l'homme du métier.

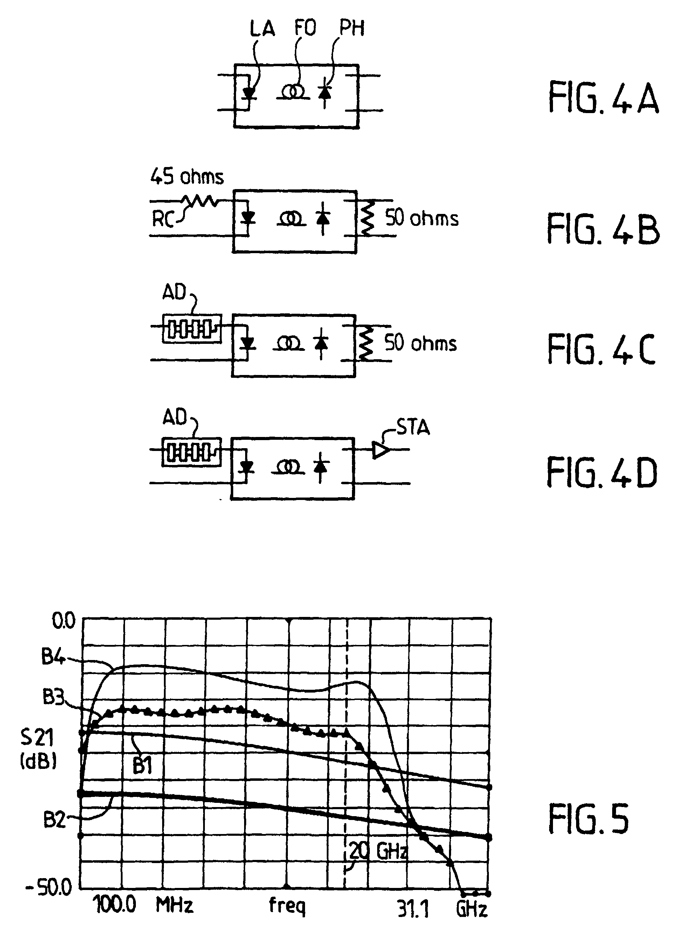

Sur les figures 4A à 4D sont représentées schématiquement des liaisons sur fibres optiques FO entre un émetteur optoélectronique de type diode laser LA et un récepteur optoélectronique de type photodiode PH.

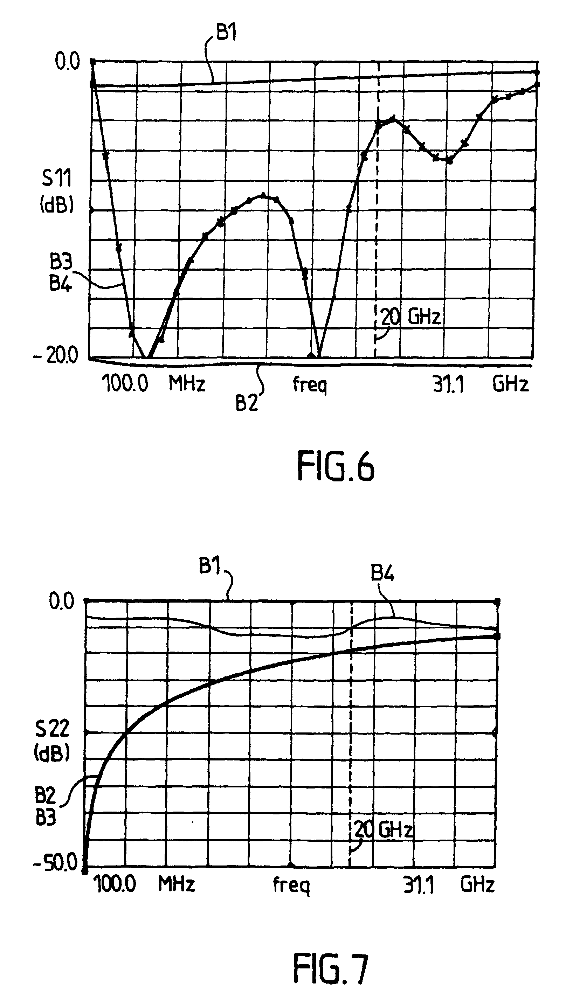

En correspondance à ces dispositifs, sont représentées sur les figures 5 à 7 des courbes représentant les bilans de ces liaisons, notamment en ce qui concerne les coefficients S21 et S11 en décibels.

Sur la figure 4A, la liaison est de type télécommunication sans adaptation d'impédance ni en entrée, ni en sortie.

Sur la figure 4B, une adaptation basse impédance, selon la technique par résistance complémentaire RC de 45 Ω, est illustrée avec en sortie une adaptation sur 50 Ω.

En figure 4C, est représentée la liaison selon l'invention dans laquelle la diode laser LA est précédée d'un amplificateur adaptateur basse impédance AD selon l'invention, avec en sortie une adaptation d'impédance 50 Ω classique.

Enfin, en figure 4D, est illustrée une liaison dans laquelle, en amont est prévu l'amplificateur distribué AD selon l'invention, et en sortie un amplificateur haute impédance spécifique STA du type de celui décrit en référence à la Demande de Brevet déposée par la Demanderesse le même jour, portant sur un amplificateur haute impédance à large bande hyperfréquences pour recevoir des signaux hyperfréquences à très large bande émanant d'une source de courant capacitive à haute impédance.

Sur les figures 5 à 7, on a représenté les bilans des liaisons décrites en référence en 4A à 4D. La courbe B1 illustre le bilan la liaison décrite en référence à la figure 4A, la courbe B2 illustre le bilan de la liaison décrite en référence à la figure 4B, la courbe B3 illustre le bilan de la liaison décrite en référence à la figure 4C et la courbe B4 illustre la liaison décrite en référence à la figure 4D.

On sait que le coefficient S21 est un coefficient de transmission qui exprime le gain en puissance de transfert d'énergie entre la diode laser et la photodiode laser. Le coefficient S11 caractérise l'adaptation d'impédance de la liaison vue de l'émission. Le coefficient S22 caractérise l'impédance de la liaison vue de la réception. Plus les coefficients S11 et S22 présentent un gain négatif en décibels, meilleure est l'adaptation.

La courbe B2 présente une très bonne adaptation en émission et en réception, mais avec un gain en puissance faible.

La courbe B3 montre que l'amplificateur distribué selon l'invention permet d'obtenir une bonne adaptation d'impédance sur la bande de fréquences s'étendant d'au moins 1 GHz jusqu'au moins 18 GHz avec une platitude de gain excellente, tout en présentant une bonne adaptation. Elle montre aussi que l'amplificateur distribué selon l'invention offre un gain de l'ordre de 10 à 15 dB par rapport aux structures de l'art antérieur (courbe B2).

Enfin, la courbe B4 montre que l'installation telle que décrite en figure 4D présente un excellent gain avec une bonne adaptation d'impédance en émission et en réception sur toute la largeur de bande s'étendant d'au moins 1 GHz jusqu'à au moins 18 GHz.

## Revendications

1. Amplificateur distribué pour signaux hyperfréquences à très large bande, destiné à être interposé entre un circuit électronique amont d'impédance prédéterminée et un circuit électronique aval de basse impédance par rapport à celle du circuit électronique amont, ledit amplificateur comprenant une pluralité de cellules amplificatrices (CE) montées chacune entre une ligne de grille (LG) et une ligne de drain (LD), chaque cellule comportant un circuit actif possédant au moins un transistor à effet de champ (T) monté en source commune, et des éléments passifs (FG et FD) servant à constituer des équivalents de tronçons de la ligne de grille et de la ligne de drain,

   **caractérisé en ce que** l'une des extrémités de la ligne de grille (LG), formant l'entrée (E) de l'amplificateur distribué, est reliée au circuit électronique amont ;

   **en ce que** l'une des extrémités de la ligne de drain (LD), formant la sortie (S) de l'amplificateur distribué, est reliée au circuit électronique aval, et

   **en ce que** éléments passifs servant à constituer les équivalents de tronçons de la ligne de drain (FD) de chaque cellule comprennent une capacité (26) montée en parallèle entre le drain et la source du transistor à effet de champ et dont la valeur varie de façon croissante d'une cellule à l'autre selon le sens de propagation des signaux hyperfréquences et conformément à une loi choisie, et des éléments inductifs (22, 24) dont les valeurs varient de façon décroissante d'une cellule à l'autre dans le sens de propagation des signaux hyperfréquences et conformément à une loi choisie, afin d'amener progressivement l'impédance caractéristique de la ligne de drain (LD) à une valeur choisie permettant une adaptation basse impédance entre les circuits électroniques amont et aval, tout en conservant un gain plat sans discontinuité sur la très large bande de fréquences.

2. Amplificateur selon la revendication 1 dans lequel des premiers moyens de polarisation appliquent une première tension de polarisation (POG) à la ligne de grille, et dans lequel des seconds moyens de polarisation appliquent une seconde tension de polarisation (POD) à la ligne de drain, **caractérisé en ce que** la première tension de polarisation (POG) est appliquée à l'autre extrémité de la ligne de grille (LG) à travers une première résistance terminale (RG) d'une valeur ohmique prédéterminée, et

   **en ce que** la seconde tension de polarisation (POD) est appliquée à l'autre extrémité de la ligne de drain (LD) à travers une seconde résistance terminale (RD) d'une valeur ohmique plus faible que celle de la première résistance terminale (RG).

3. Amplificateur selon la revendication 1, **caractérisé** en que le circuit électronique aval a une impédance caractéristique de quelques Ohms, tandis que le circuit électronique amont a une impédance caractéristique égale à 50 Ω.

4. Amplificateur selon l'une quelconque des revendications précédentes, dans lequel le circuit électronique aval comprend une diode laser capable d'émettre des signaux hyperfréquences à très large bande.

**5.** Amplificateur selon l'une quelconque des revendications précédentes, dans lequel la bande des signaux hyperfréquences s'étend d'au moins 1 GHz jusqu'à au moins 18 GHz.

**6.** Amplificateur selon l'une des revendications précédentes, dans lequel le nombre de cellules amplificatrices est de 4, dans lequel la valeur ohmique de la première résistance terminale (RG) est de 50 Ω, et dans lequel la valeur ohmique de la seconde résistance terminale (RD) est de 10 Ω.

**7.** Utilisation de l'amplificateur selon l'une des revendications précédentes dans la fabrication de circuits intégrés monolithiques hyperfréquences, destinés à la transmission de signaux hyperfréquences sur fibres optiques.

**Patentansprüche**

**1.** Kettenverstärker für sehr breitbandige Höchstfrequenzsignale, der dazu bestimmt ist, zwischen eine elektronische Eingangsschaltung vorbestimmter Impedanz und eine elektronische Ausgangsschaltung mit gegenüber der elektronischen Eingangsschaltung niedriger Impedanz eingefügt zu werden und der mehrere Verstärkerstufen (CE) aufweist, die jeweils zwischen eine Gateleitung (LG) und eine Drainleitung (LD) eingeschaltet sind und jeweils eine aktive Schaltung, die wenigstens einen in Sourceschaltung angeschlossenen Feldeffekttransistor (T) besitzt, und passive Elemente (FG und FD) aufweist, die dazu dienen, Äquivalente von Endstücken der Gateleitung und der Drainleitung zu bilden,
**dadurch gekennzeichnet, daß** eines der Enden der Gateleitung (LG), das den Eingang (E) des Kettenverstärkers bildet, mit einer elektronischen Eingangsschaltung verbunden ist;
daß eines der Enden der Drainleitung (LD), das den Ausgang (S) des Kettenverstärkers bildet, mit einer elektronischen Ausgangsschaltung verbunden ist, und
daß die passiven Elemente, die dazu dienen, Äquivalente von Endstücken der Drainleitung (FD) jeder Stufe zu bilden, eine Kapazität (26) enthalten, die parallel zwischen Drain und Source des Feldeffekttransistors geschaltet ist und deren Größe zunehmend von einer Stufe zur anderen in Ausbreitungsrichtung der Höchstfrequenzsignale und entsprechend einem gewählten Gesetz variiert, und induktive Bauelemente (22, 24) enthalten, deren Werte von einer Stufe zur nächsten in Ausbreitungsrichtung der Höchstfrequenzsignale entsprechend einem gewählten Gesetz abnehmend variieren, um die Eigenimpedanz der Drainleitung (LD) progressiv an einen gewählten Wert anzugleichen, der eine Niedrigimpedanzanpassung zwischen den elektronischen Ein- und Ausgangsschaltungen zu ermöglichen und dabei eine glatte Verstärkung ohne Diskontinuitäten in dem sehr breiten Frequenzbereich zu bewahren.

**2.** Verstärker nach Anspruch 1, bei dem erste Vorspanneinrichtungen eine erste VorSpannung (POG) an die Gateleitung anlegen und zweite Vorspanneinrichtungen eine zweite Vorspannung (POD) an die Drainleitung anlegen, **dadurch gekennzeichnet, daß** die erste Vorspannung (POG) an das andere Ende der Gateleitung (LG) über einen ersten Abschlußwiderstand (RG) eines vorbestimmten Ohm-Wertes angelegt ist, und
daß die zweite Vorspannung (POD) an das andere Ende der Drainleitung (LD) über einen zweiten Abschlußwiderstand (RD) eines Ohm-Wertes angelegt ist, der kleiner als jener des ersten Abschlußwiderstandes (RG) ist.

**3.** Verstärker nach Anspruch 1, **dadurch gekennzeichnet, daß** die Ausgangsschaltung eine Eigenimpedanz von einigen Ohm hat, während die elektronische Eingangsschaltung eine Eigenimpedanz von 50 Ω hat.

**4.** Verstärker nach einem der vorhergehenden Ansprüche, bei dem die elektronische Ausgangsschaltung eine Laserdiode enthält, die in der Lage ist, Höchstfrequenzsignale sehr großer Bandbreite abzugeben.

**5.** Verstärker nach einem der vorhergehenden Ansprüche, bei dem das Höchstfrequenzsignalband sich von wenigstens 1 GHz bis wenigstens 18 GHz erstreckt.

**6.** Verstärker nach einem der vorhergehenden Ansprüche, bei dem die Anzahl der Verstärkerstufen gleich 4 ist, wobei der Ohm-Wert des ersten Abschlußwiderstandes (RG) 50 Ω ist und der Ohm-Wert des zweiten Abschlußwiderstandes (RD) 10 Ω ist.

**7.** Verwendung des Verstärkers nach einem der vorhergehenden Ansprüche bei der Herstellung von monolithischen integrierten Höchsfrequenzschaltungen, die zur Übertragung von Höchstfrequenzsignalen über optische Fasern bestimmt sind.

**Claims**

**1.** Distributed amplifier for very wide band microwave signals, intended to be interposed between an upstream electronic circuit of predetermined impedance and a downstream electronic circuit of low impedance with respect to that of the upstream electronic circuit, the said amplifier comprising a plurality of amplifying cells (CE) each arranged between a gate line (LG) and a drain line (LD), each cell comprising an active circuit possessing at least one field effect transistor (T) arranged in common source mode, and passive elements (FG and FD) serving to constitute equivalents of stretches of the gate line and of the drain line,
**characterized in that** one of the ends of the gate line (LG), forming the input (E) of the distributed amplifier, is linked to the upstream electronic circuit;
**in that** one of the ends of the drain line (LD), forming the output (S) of the distributed amplifier, is linked to the downstream electronic circuit, and
**in that** passive elements serving to constitute the equivalents of stretches of the drain line (FD) of each cell comprise a capacitance (26) arranged in parallel between the drain and the source of the field effect transistor and whose value varies in a manner increasing from one cell to another in the direction of propagation of the microwave signals and in accordance with a chosen law, and inductive elements (22, 24) whose values vary in a manner decreasing from one cell to another in the direction of propagation of the microwave signals and in accordance with a chosen law, in such a way that the characteristic impedance of the drain line (LD) is brought progressively to a chosen value allowing low impedance matching between the upstream and downstream electronic circuits, while preserving a flat gain with no discontinuity over the very wide frequency band.

2. Amplifier according to Claim 1, in which first biasing means apply a first biasing voltage (POG) to the gate line, and in which second biasing means apply a second biasing voltage (POD) to the drain line, **characterized in that** the first biasing voltage (POG) is applied to the other end of the gate line (LG) across a first terminal resistor (RG) of a predetermined ohmic value, and
**in that** the second biasing voltage (POD) is applied to the other end of the drain line (LD) across a second terminal resistor (RD) of a smaller ohmic value than that of the first terminal resistor (RG).

3. Amplifier according to Claim 1, **characterized in that** the downstream electronic circuit has a characteristic impedance of a few ohms, while the upstream electronic circuit has a characteristic impedance equal to 50 $\Omega$.

4. Amplifier according to any one of the preceding claims, in which the downstream electronic circuit comprises a laser diode capable of emitting very wide band microwave signals.

5. Amplifier according to any one of the preceding claims, in which the band of the microwave signals extends from at least 1 GHz up to at least 18 GHz.

6. Amplifier according to any one of the preceding claims, in which the number of amplifying cells is 4, in which the ohmic value of the first terminal resistor (RG) is 50 $\Omega$, and in which the ohmic value of the second terminal resistor (RD) is 10 $\Omega$.

7. Use of the amplifier according to one of the preceding claims in the manufacture of monolithic microwave integrated circuits, intended for the transmission of microwave signals over optical fibres.

FIG.1 ART ANTERIEUR

FIG.2

EP 0 801 467 B1

FIG.3

LA   FO   PH

FIG. 4A

45 ohms

RC

50 ohms

FIG. 4B

AD

50 ohms

FIG. 4C

AD

STA

FIG. 4D

0.0

B4

B3

S21
(dB)

B1

B2

20 GHz

-50.0

100.0   MHz        freq          31.1   GHz

FIG. 5

12

FIG.6

FIG.7